**Europäisches Patentamt**

**European Patent Office**

**Office européen des brevets**

(11) Veröffentlichungsnummer: **0 577 678 B1**

# (12) EUROPÄISCHE PATENTSCHRIFT

(45) Veröffentlichungstag der Patentschrift: **08.03.95**

(51) Int. Cl.6: **C23C 16/40**, C23C 16/50, C04B 41/50

(21) Anmeldenummer: **92907494.6**

(22) Anmeldetag: **27.03.92**

(86) Internationale Anmeldenummer:
**PCT/DE92/00249**

(87) Internationale Veröffentlichungsnummer:
**WO 92/17623 (15.10.92 92/26)**

(54) **VERBUNDKÖRPER, VERWENDUNG DES VERBUNDKÖRPERS UND VERFAHREN ZU SEINER HERSTELLUNG.**

(30) Priorität: **27.03.91 DE 4110006**
**27.03.91 DE 4110005**

(43) Veröffentlichungstag der Anmeldung:
**12.01.94 Patentblatt 94/02**

(45) Bekanntmachung des Hinweises auf die
Patenterteilung:
**08.03.95 Patentblatt 95/10**

(84) Benannte Vertragsstaaten:
**AT BE CH DE ES FR GB IT LI LU NL SE**

(56) Entgegenhaltungen:
**EP-A- 0 408 535**
**WO-A-88/07596**
**WO-A-90/06380**
**DE-A- 2 253 745**
**FR-A- 2 144 824**

(73) Patentinhaber: **Krupp Widia GmbH**
**Münchener Str. 90**
**D-45145 Essen (DE)**

(72) Erfinder: **VAN DEN BERG, Hendrikus**
**Ligusterpad 41**
**NL-5925 BT Venlo-Blerik (NL)**
Erfinder: **KÖNIG, Udo**
**Helgolangring 31**
**D-4300 Essen 1 (DE)**
Erfinder: **REITER, Norbert**
**Hunsrückstra e 29**
**D-4020 Mettmann (DE)**
Erfinder: **TABERSKY, Ralf**
**In den Weywiesen 54**
**D-4250 Bottrop (DE)**

(74) Vertreter: **Vomberg, Friedhelm, Dipl.-Phys.**
**Schulstrasse 8**
**D-42653 Solingen (DE)**

EP 0 577 678 B1

Rank Xerox (UK) Business Services
(3.10/3.09/3.3.3)

EP 0 577 678 B1

**Beschreibung**

Die Erfindung betrifft einen Verbundkörper, bestehend aus einem Hartmetall- oder Cermet-Substratkörper oder einem Substratkörper aus einer Nickel- oder Cobaltbasislegierung und einer oder mehreren Oberflächenschichten, von denen mindestens eine, vorzugsweise die äußere aus $\alpha$-$Al_2O_3$ besteht, ferner die Verwendung dieses Verbundkörpers und ein Verfahren zu seiner Herstellung.

Bereits in der DE 22 33 700 C2 wird vorgeschlagen, Hartmetall-Substratkörper, die aus einem Gemisch aus wenigstens einem als Bindemittel dienenden Metall und wenigstens einem Metallcarbid von hoher Härte bestehen, mit einer aus Aluminiumoxid oder Zirkoniumoxid bestehenden Beschichtung zu versehen. Der Substratkörper kann insbesondere aus Wolfram-, Titan-, Tantal- oder Niobcarbid oder einem Mischcarbid aus Tantal und Niob bestehen, wobei als Bindemittel beispielsweise die Metalle Cobalt, Eisen oder Nickel dienen. Vielfach werden in der Literatur auch Hartmetalle auf der Basis von Titancarbid oder Titancarbonitrid als Cermets bezeichnet, die ebenso als Substratwerkstoff verstanden werden sollen wie reine Kombinationen eines Hartmetalles mit keramischen, also nicht metallischen Bestandteilen. Die erwähnten Schichten aus $\alpha$-Aluminiumoxid werden nach der DE 22 33 700 C2 mittels CVD bei Substrattemperaturen von 1000°C aufgetragen.

Entsprechendes gilt für die Hartmetallkörper nach der DE 22 53 745 A1, die aus einem gesinterten Hartmetallsubstratkörper, einer Zwischenschicht aus Titancarbid und einer äußeren Schicht aus Aluminiumoxid bestehen, wobei die erste Titancarbid-Zwischenschicht bei 1000°C und die zweite Aluminiumoxid-Schicht bei 1100°C mittels des CVD-Verfahrens aufgebracht werden soll. Wie insbesondere in der DE 28 25 009, Spalte 2, Zeilen 28 ff., ausgeführt wird, sind harte, polykristalline und kompakte $\alpha$-Aluminiumoxid-Schichten normalerweise nur bei Ablagerungstemperaturen oberhalb von 950°C herzustellen. Bei niedrigeren Ablagerungstemperaturen werden nach dem Stand der Technik lose und pulverförmige Ablagerungen erhalten, die aus der $\gamma$-Modifikation und/oder der $\zeta$-Modifikation des Aluminiumoxids bestehen. Bei Ablagerungstemperaturen von etwa 1000°C und darüber jedoch ist die Aluminiumoxidphase normalerweise die für die Beschichtung von Werkzeugen als geeignet angesehene $\chi$-Modifikation. Um der Gefahr zu begegnen, mehrphasige Aluminiumoxid-Beschichtungen zu erhalten, die angeblich bei niedrigeren Abscheidetemperaturen als 1000°C auftreten und die eine erhebliche mechanische Schwäche und deshalb der Grund für vorzeitige Werkzeugfehler seien, wird vorgeschlagen, daß die Aluminiumoxid-Beschichtung ganz oder zu wenigstens 85 % aus der $\chi$-Modifikation besteht und daß ein ggf. aus der $\alpha$-Modifikation bestehende Rest auf der Oberfläche Bereiche bzw. Flecke mit einer Größe von höchstens 10 $\mu$m bildet. Zur Abscheidung wird das CVD-Verfahren bei Temperaturen von ca. 1000°C vorgeschlagen.

Um die bei hohen Abscheidetemperaturen entstehenden Probleme zu vermeiden, wird in der DE 32 34 943 beschrieben, eine amorphe Aluminiumoxid-Schicht aufzutragen. Eingehende Versuche mit amorphen Aluminiumoxid-Schichten, die mittels PVD abgeschieden worden sind, zeigten jedoch, daß rein amorphe Aluminiumoxid-Schichten ein glasartiges Bruchverhalten haben und somit keine signifikante Verbesserung im Verschleißverhalten ergeben können. Bei unterbrochenen Schnitten neigen diese Schichten zum Absplittern.

In der DE 24 28 530 A1 wird ein Verfahren zum Schutz eines Metallteiles gegen Korrosion und Verschleiß vorgeschlagen, das in reinem oder legiertem Zustand mindestens ein zur Gruppe I B des periodischen Systems der Elemente gehörendes Element enthält und bei dem auf die Oberfläche dieses Teiles eine Schicht aus amorphem und durchsichtigem Aluminiumoxid durch chemische Abscheidung aus der Dampfphase aufgebracht ist. Die bei Temperaturen zwischen 300 und 800°C aufgebrachten amorphen Schichten sind jedoch gegen thermische Einwirkungen weit weniger stabil als beispielsweise die als Korund bekannte Modifikation des Aluminiumoxids ($\alpha$-$Al_2O_3$).

Grundsätzlich ist es auch bekannt, Aluminiumoxidschichten als Schutzschichten gegen Heißgaskorrosion einzusetzen, z.B. in Verbrennungskraftmaschinen. In diesem Falle sind neben der mechanischen Stabilität der Beschichtung auch besondere Anforderungen an die Dichtheit der Schicht zu stellen. Schichten, die ganz oder teilweise aus $\chi$-$Al_2O_3$ bestehen, erfahren bei der Einwirkung von hohen Temperaturen eine Umwandlung in $\alpha$-$Al_2O_3$, wobei Risse entstehen. Sie sind daher als Schutzschicht gegen Heißgaskorrosion nicht geeignet. Nach dem Stand der Technik kann dies nur durch vergleichsweise (ca. 500 $\mu$m) dicke, durch thermisches Spritzen hergestellte Keramikschichten erreicht werden.

Es ist daher Aufgabe der vorliegenden Erfindung, den eingangs genannten Verbundkörper hinsichtlich der Schutzwirkung und der mechanischen Verschleißeigenschaften der $\alpha$-Aluminiumoxid-Schicht zu verbessern.

Diese Aufgabe wird durch den Verbundkörper nach Anspruch 1 gelöst, dessen kennzeichnendes Merkmal in einer feinstkristallinen Struktur der $\alpha$-Aluminiumoxid-Schicht besteht. Ein Maß für die Kristallgröße des polykristallinen $\alpha$-Aluminiumoxid-Gefüges liefert das Röntgenbeugungsdiagramm. Die Linienbreiten

2

der Interferenzlinien sind bei der verwendeten CuK$_\alpha$-Strahlung und unter gleicher Winkelstellung 2 $\theta$ des die Strahlung registrierenden Zählrohres und bei gleicher Apertur des Strahlenkollimators um so schmaler, je größer die interferierenden einkristallinen Kristallite oder je größer die mittlere Korngröße des polykristallinen Materials (hier $\alpha$-Aluminiumoxid) ist. Dieser Zusammenhang wird durch die von W. Scherrer abgeleitete Formel B$_{1/2}$ = k $\cdot$ $\lambda$/($\langle$d$\rangle$ $\cdot$ cos$\theta$) beschrieben. $\lambda$ ist die Wellenlänge der Röntgenstrahlung, $\langle$d$\rangle$ die mittlere lineare Ausdehnung des reflektierenden Kristallites, $\theta$ der Glanzwinkel und k eine Konstante. Die Linienbreite der Röntgenbeugungsdiagramme kann somit insbesondere bei sehr feinen, submikroskopischen Kristallen als leicht zugängliches Maß für die mittlere Korngröße verwendet werden. Als Vergleichsgröße gilt die Halbwertsbreite der mit derselben Röntgenstrahlung gemessenen Beugungslinie bei Untersuchung eines pulverförmigen Körpers aus $\alpha$-Al$_2$O$_3$ oder einer mit einem CVD-Verfahren bei 1000°C bis 1100°C aufgetragenen $\alpha$-Al$_2$O$_3$-Schicht.

Vorzugsweise wird als Maß die durch die Miller-Indizes (113) indizierte und beim Beugungswinkel von 43,4° der 2$\theta$-Skala bei CuK$_\alpha$ -Röntgenstrahlung auftretende Röntgenbeugungslinie zugrundegelegt, deren Halbwertsbreite, vorzugsweise mindestens vierfache Halbwertsbreite der entsprechenden Röntgenbeugungslinie von pulverförmigem Aluminiumoxid als Maß für die Feinkörnigkeit der hexagonal dicht gepackten Kristallstruktur des Aluminiumoxids zugrundegelegt.

Nach einer Weiterbildung der Erfindung soll die Dicke der Aluminiumoxid-Beschichtung 1 bis 12 $\mu$m, vorzugsweise 2 bis 6 $\mu$m, betragen.

Nach einer weiteren Ausgestaltung der Erfindung besteht die BeSchichtung aus Aluminiumoxid aus 49 bis 52,5 Massen-% Aluminium, 46 bis 47,5 Massen-% Sauerstoff und 0,5 bis 3,5 Massen-% Chlor.

Je nach Anwendungszweck haben sich auch Verbundkörper mit mindestens einer Zwischenschicht aus Carbiden, Carbonitriden, Nitriden, Boriden und/oder Oxiden der Elemente der Gruppen IVa bis VIa des Periodensystems als vorteilhaft erwiesen. Hiermit sind ausdrücklich Mehrlagenbeschichtungen aus Titancarbid, Titannitrid und Aluminiumoxid angesprochen.

Die erfindungsgemäß nach dem Hauptanspruch ausgeführten Verbundkörper mit Schutzschichten aus feinkristallinem $\alpha$-Al$_2$O$_3$ haben nach den Ergebnissen der ausgeführten Versuche den Stand der Technik übertreffende Eigenschaften, insbesondere Hartmetall- oder Cermet-Substratkörper mit einer oder mehreren Oberflächenschichten ausgezeichnete Zerspanungsleistungen. Jedoch wiesen auch Schutzschichten, deren Beschichtung nur zum Teil aus feinkristallinem $\alpha$-Al$_2$O$_3$, zum übrigen Teil jedoch aus amorphem Al$_2$O$_3$ oder aus Al$_2$O$_3$ mit nanokristallinen Gefügeanteilen bestand, im Vergleich zum Stand der Technik noch wesentlich verbesserte Gebrauchseigenschaften auf. Nanokristalline Gefügeanteile haben Kristallite von nur einigen Nanometer Ausdehnung und können wegen ihrer Kleinheit keine gut ausgeprägten Röntgeninterferenzen erzeugen.

In einer weiteren Ausgestaltung der Erfindung ist daher vorgesehen, Beschichtungen zu verwenden, die zum Teil aus feinkristallinem $\alpha$-Al$_2$O$_3$ und/oder nanokristallinem Al$_2$O$_3$ und zum anderen Teil aus amorphen Al$_2$O$_3$ bestehen. Schutzschichten, die vollständig aus amorphem Al$_2$O$_3$ bestanden, erwiesen sich jedoch als nicht brauchbar, da diese Beschichtungen sehr spröde waren und bei thermischen und mechanischen Belastungen zur Rißbildung und zum Absplittern neigten, insbesondere im Rahmen ihrer Verwendung bei Schneidwerkzeugen.

In einem amorphen Material besteht keinerlei Fernordnung oder Periodizität in der räumlichen Anordnung der Atome. Der Nachweis, ob eine Beschichtung feinstkristallin und/oder nanokristallin oder vollständig amorph ist, kann auch durch eine Untersuchung mit einem Elektronenmikroskop geführt werden. Im Falle der Feinstkristallinität oder Nanokristallinität beobachtet man Interferenzmuster (Debye-Scherrer-Ringe), die eindeutig bestimmten Netzebenen der betreffenden Kristallphasen zugeordnet werden können. Hierauf gründet sich eine weitere Ausgestaltung der Erfindung.

Der erfindungsgemäße Verbundkörper kann zu verschiedenen technischen Zwecken eingesetzt werden. Verbundkörper mit einem Hartmetall- oder Cermet-Substratkörper werden vorzugsweise als Schneidwerkstoff zur spanenden Bearbeitung, insbesondere in Form von Wendeschneidplatten verwendet. Eine weitere Anwendung gründet sich auf der Dichtheit und der Oxidationsbeständigkeit der Schutzschicht. Da die durch das erfindungsgemäße Verfahren hergestellten Schichten Druckspannungen aufweisen, bleibt die Beschichtung auch bei hohen Temperaturen und der dadurch bedingten Ausdehnung des Grundkörpers noch dicht, d.h., es entstehen keine Risse. Die Schutzschicht ist daher hervorragend zur Auskleidung von Brennkammern oder zum Schutz von beweglichen Teilen in Brennkammern geeignet, insbesondere mit Verbundkörpern, deren Substratkörper aus Stahl oder einer Nickel- oder Cobaltbasislegierung besteht.

Da Aluminiumoxid gegen Stahl als Gegenkörper einen sehr geringen Reibungskoeffizienten aufweist, kann die erfindungsgemäße Schutzschicht auch zur Reibungsverminderung und zur Verschleißminderung von aneinanderreibenden Teilen, wie z.B. bei Nockenwellen angewendet werden.

Das ausgezeichnete Haftungsvermögen kann zur Verbesserung der Haftung von anderen Hartstoffschichten ausgenützt werden. So kann beispielsweise die an den Substratkörper angrenzende Schicht aus Aluminiumoxid und die äußere Schicht aus Titannitrid bestehen, wobei das Aluminiumoxid ein gutes Haftvermögen hinsichtlich des Titannitrids bietet.

Zur Herstellung der feinkörnigen $\alpha$-Aluminiumoxid-Beschichtung wird erfindungsgemäß ein Plasma-CVD-Verfahren bei Substrattemperaturen von 400 bis 750 °C angewendet, bei dem die Plasmaaktivierung an dem als Kathode geschalteten Substratkörper mit einer gepulsten Gleichspannung herbeigefügt wird. Die niedrigen Beschichtungstemperaturen durch Auswahl des Plasma-CVD-Verfahrens führen zu einer Verbesserung der Haftung der Aluminiumoxidoberflächenschicht. Der Substratkörper wird bis auf die Auflagepunkte vollständig und gleichmäßig von der Schicht bedeckt, ohne die ansonsten bei PVD-Verfahren auftretenden Abschattungseffekte. Vorzugsweise wird die Beschichtung jedoch bei Temperaturen zwischen 450 und 650 °C durchgeführt. Die gepulste Gleichspannung hat Maximalwerte zwischen 200 und 900 V.

Die Qualität der Beschichtung wird weiterhin dadurch verbessert, daß zwischen den negativen Gleichspannungsimpulsen (Rechteckimpulsen) in den Pulspausen eine Restgleichspannung aufrechterhalten bleibt, die größer als das niedrigste Ionisierungspotential der am CVD-Prozeß beteiligten Gasmoleküle, jedoch nicht größer als 50 % des Maximalwertes der gepulsten Gleichspannung ist. Hierbei kommt es primär nicht auf den Spannungsverlauf bzw. die Gleichmäßigkeit der Restgleichspannung an, sondern lediglich darauf, daß über die gesamte Zeit zwischen zwei Rechteckimpulsen die Restgleichspannung stets größer als das genannte Ionisierungspotential ist. Im folgenden sind einige der für den CVD-Proze von Aluminiumoxid maßgeblichen Ionisierungspotentiale angegeben:

H: 13,5 eV, $H_2$: 15,8 eV,

Ar: 15,7 eV,

O : 13,6 eV, $O_2$ : 12,1 eV,

$AlCl_3$: 11,0 eV.

Nach einer Weiterbildung der Erfindung liegt das Verhältnis der Restgleichspannung zum Maximalwert der gepulsten Gleichspannung zwischen 0,02 und 0,5.

Die Periodendauer der gepulsten Gleichspannung soll vorzugsweise zwischen 20 $\mu$s und 20 ms liegen, wobei man unter der Periodendauer die Dauer eines Rechteckimpulses und einer Pulspause versteht. Vorzugsweise wird das Verhältnis der Pulsdauer zu der Periodendauer zwischen 0,1 bis 0,6 gewählt. Die Parameter werden schließlich so eingestellt, daß eine Schichtwachstumsgeschwindigkeit von 0,5 bis 10 $\mu$m/h erreicht wird.

Das geschilderte Verfahren zur Aluminiumoxid-Beschichtung ist zwar grundsätzlich bereits in der DE 38 41 730 A1 beschrieben und kann auch zur Beschichtung aus verschiedenen anderen Hartstoffen, wie Carbiden, Nitriden, Boriden, Siliciden und Oxiden mit einer besonders großen Härte und einem hohen Schmelzpunkt, also z.B. Titancarbid, Titannitrid, Titancarbonitrid, Zirkoniumoxid, Borcarbid, Siliciumcarbid und Titandiborid verwendet werden, jedoch war es überraschend, daß entgegen den in der zum Stand der Technik gehörenden Literatur geäußerten Befürchtungen die Scnutzschichten eine unerwartet feinkörnige $\alpha$-Aluminiumoxid-Modifikation ohne weitere kristalline Phasen aufwiesen.

Vorzugsweise wird als Hartstoff-bildende reaktive Gasatmosphäre aus Aluminiumchlorid, Kohlendioxid und Wasserstoff, die durch eine Glimmentladung teilweise ionisiert wird, verwendet. Als bevorzugten Gasdruck beim Beschichten werden 200 bis 300 Pascal eingestellt.

Weiterbildungen der Erfindung und sich gegenüber dem Stand der Technik ergebende Vorteile werden im folgenden anhand von Zeichnungen erläutert. Es zeigen

Fig. 1a    Gefüge der Beschichtung einer nach dem Stand der Technik mit TiC and $\alpha$-$Al_2O_3$ beschichteten Wendeschneidplatte; rasterelektronenmikroskopische Aufnahme, Vergrößerung 4250 : 1,

Fig. 1b    Gefüge der Beschichtung einer mit erfindungsgemäß feinkristallinem $\alpha$-$Al_2O_3$ beschichteten Wende schneidplatte; rasterelektronenmikroskopische Aufnahme, Vergrößerung 8250 : 1,

Fig. 2a    das Linienprofil einer nach dem Stand der Technik bekannten kompakten Aluminiumoxidprobe,

Fig. 2b    das Linienprofil einer durch CVD bei ca. 1000 °C auf einem zuvor mit Titancarbid beschichteten Hartmetallsubstrat abgeschiedenen $\alpha$-Aluminiumoxid-Schicht und

Fig. 2c    das Linienprofil der erfindungsgemäßen $\alpha$-Aluminiumoxid-Beschichtung, ferner

Fig. 3    die Kolktiefe KT und die Verschleißmarkenbreite VB in Abhängigkeit von dem Fräsweg $l_f$ auf dem Werkstückstoff Cm 60V und

Fig. 4    die Kolktiefe KT und die Verschleißmarkenbreite VB in Abhängigkeit von dem Fräsweg $l_f$ auf dem Werkstückstoff 42CrMo4V,

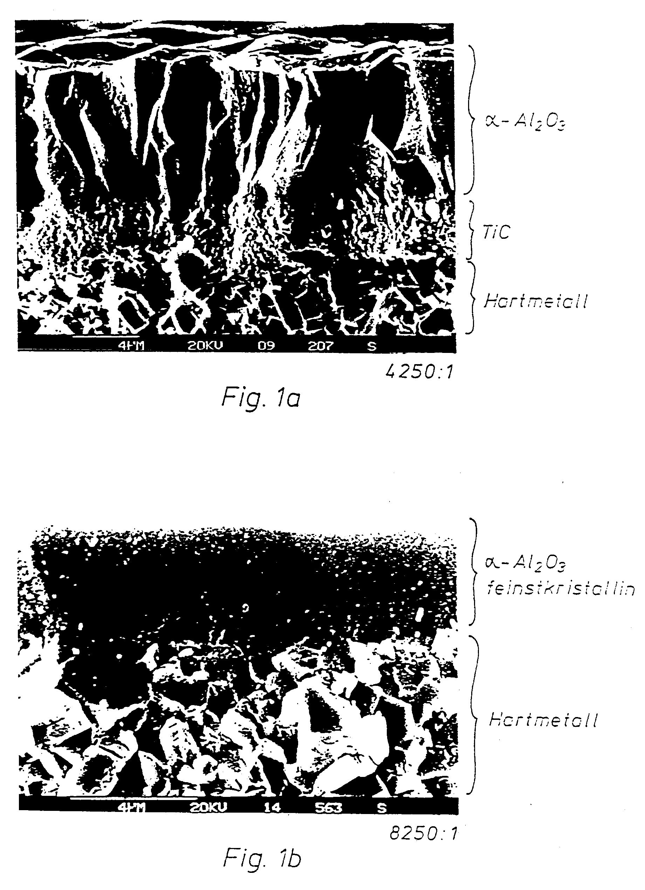

Das abgeschiedene $\alpha$-Aluminiumoxid hat eine sehr feinkörnige Gefügestruktur. Durch Untersuchungen mit einem Raster-Elektronenmikroskop kann der Unterschied der Gefügestruktur im Vergleich zu einer bekannten Aluminiumoxidbeschichtung, die durch CVD bei etwa 1000 °C hergestellt wurde, sehr gut nachgewiesen werden. Die Bilder Fig. 1a und 1b zeigen die Strukturen einer nach dem Stand der Technik mit TiC und $\alpha$-Aluminiumoxid (Fig. 1a) und einer erfindungsgemäß (Fig. 1b) beschichteten Wendeschneidplatte, die beim Brechen der Platten entstehen. Das wesentlich feinere Kristallgefüge der Schicht ist sehr gut zu erkennen.

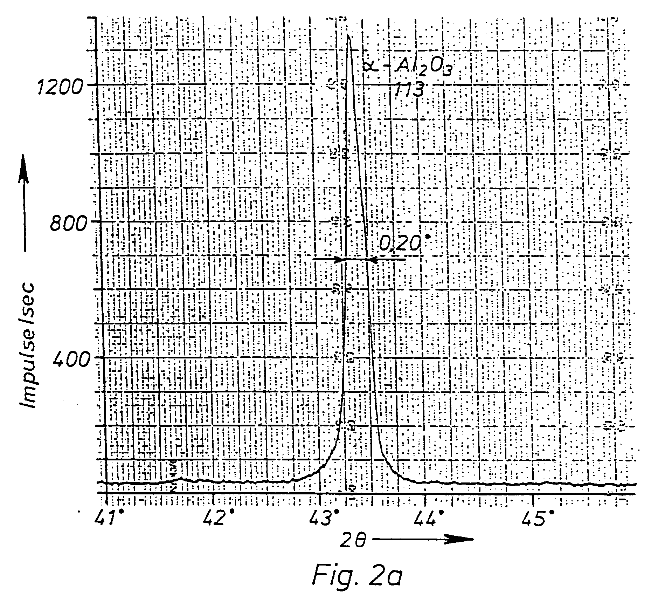

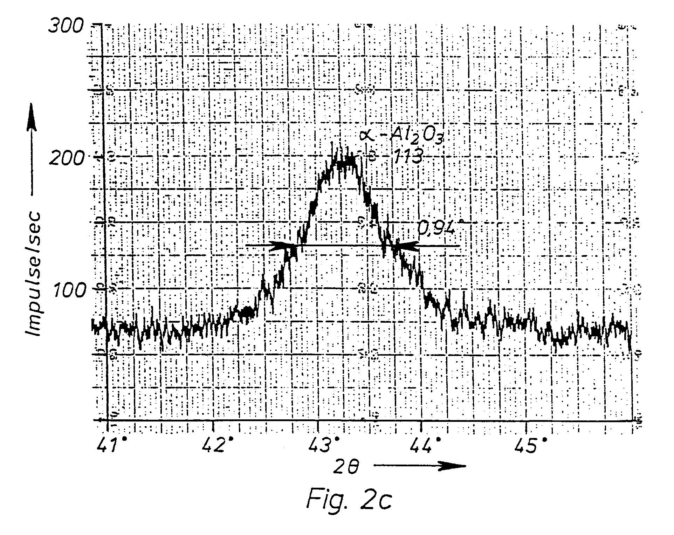

Vorausgeschickt werden soll zu der Erläuterung der Fig. 2a bis 2c die Bemerkung, daß jede Kristallstruktur, wie z.B. das $\alpha$-Al$_2$O$_3$ oder das $\gamma$-Al$_2$O$_3$ bei bestimmten Beugungswinkeln 2O, die durch die sogenannten Miller-Indizes gekennzeichneten Interferenzlinien zeigt. Zum Beispiel treten bei $\gamma$-Al$_2$O$_3$ bei anderen Beugungswinkeln $2\theta$ als bei $\alpha$-Al$_2$O$_3$ jeweils strukturspezifische Interferenzlinien auf, so daß ein Röntgenbeugungsdiagramm als eine Art Fingerabdruck für die Identifizierung von Kristallstrukturen und den Modifikationen eines festen Stoffen angesehen werden kann.

Wie bereits oben erwähnt, stehen die Halbwertsbreiten in unmittelbarem proportionalen Zusammenhang zu der mittleren Größe des reflektierenden Kristalles.

Fig. 2a zeigt einen Ausschnitt aus dem Linienprofil eines kompakten Aluminiumoxid-Körpers. Die Halbwerts-Linienbreite des (113)-Reflexes beträgt 0,2 ° der $2\theta$-Skala bei Verwendung von CuK$_\alpha$ -Strahlung.

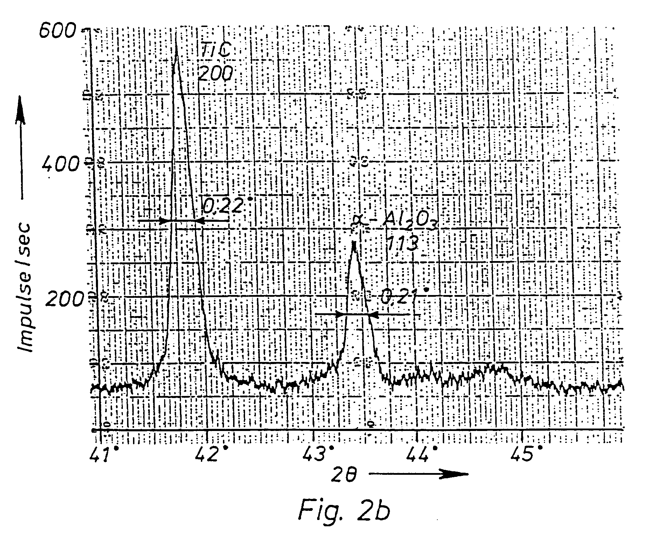

Demgegenüber zeigt Fig. 2b das Linienprofil einer durch CVD bei ca. 1000 °C auf einem zuvor mit Titancarbid beschichteten Hartmetallsubstrat abgeschiedenen $\alpha$-Aluminiumoxid-Schicht, wobei neben der durch den (113)-Reflex gekennzeichneten typischen $\alpha$-Aluminiumoxid-Linie noch die für Titancarbid typische Beugungslinie des (200)-Reflexes sichtbar ist. Wie Fig. 2b verdeutlicht, beträgt die Halbwertsbreite der $\alpha$-Aluminiumoxid-Linie 0,21 ° der $2\theta$-Skala, die damit (im Rahmen der Meßgenauigkeit) gleich der Fig. 2a entnehmbaren Halbwertsbreite ist. Dies verdeutlicht, daß die mittlere Korngröße des durch CVD bei 1000 °C abgeschiedenen $\alpha$-Aluminiumoxid praktisch gleich der Korngröße der kompakten $\alpha$-Aluminiumoxid-Probe nach Fig. 2a ist. Hingegen beträgt die Halbwertsbreite der $\alpha$-Al$_2$O$_3$-Linie des (113)-Reflexes einer erfindungsgemäß hergestellten Probe 0,94 ° der $2\theta$-Skala (siehe Bild 2c). Verbundkörper mit der erfindungsgemäßen feinkristallinen $\alpha$-Al$_2$O$_3$-Beschichtung haben somit eine Linienbreite, die mindestens um das dreifache, im vorliegenden Fall das nahezu fünffache der bei Kompaktkörpern (siehe Fig. 2a) entstehenden natürlichen Linienbreite beträgt.

Die mit der erfindungsgemäßen Aluminiumoxid-Beschichtung ausgestatteten Schneidkörper weisen überragende, den bisherigen Stand der Technik weiter übertreffende Standzeiten oder Gebrauchsdauern auf, was an dem folgenden Ausführungsbeispiel deutlich wird:

Aus einem Hartmetall der Zerspanungsanwendungsklasse M25 (nach DIN-Norm 4990) wurden 1000 Wendeschneidplatten der geometrischen Form SEKN1203AFN (Bezeichnung nach DIN 4987) hergestellt. Jeweils Teilmengen aus diesem Fertigungslos wurden durch verschiedene Methoden beschichtet, die der folgenden Tabelle 1 zu entnehmen sind.

Tabelle 1

| Ausführung | Verfahren | Beschichtungs temperatur | Schichtstoff | Schichtdicke |
|---|---|---|---|---|
| 1 | CVD | 1000 °C | TiC + $\alpha$-Al$_2$O$_3$ | 2 + 6 $\mu$m |
| 2 | PVD | 500 °C | (Ti,Al)N | 6 $\mu$m |
| 3 | PCVD | 550 °C | TiN | 5 $\mu$m |
| 4 | PCVD | 600 °C | $\alpha$-Al$_2$O$_3$ | 5 $\mu$m |

Im Ausführungsbeispiel 1 wurden Wendeschneidplatten nach dem in der DE-PS 22 33 700 beschriebenen CVD-Verfahren beschichtet. Um eine gute Haftung der Aluminiumoxid-Schicht auf den Wendeschneidplatten zu erhalten, wurde, wie in DE 22 53 745 A1 beschrieben, vor dem Aufbringen der Schicht aus Aluminiumoxid eine Zwischenschicht aus Titancarbonitrid von 2 $\mu$m Dicke, ebenfalls durch CVD, auf den Hartmetallkörper abgeschieden.

Nach dem Ausführungsbeispiel 2 ist ein Target aus einer Titan-Aluminium-Legierung im Hochvakuum mit einem Teildruck von ca. 0,1 Pascal Stickstoff zerstäubt worden. Das verwendete PVD-Verfahren und die damit hergestellte Verschleißschutzschicht bzw. Schichten aus dem Hartstoff (Ti, Al)N haben sich in der Vergangenheit gut bewährt.

Entsprechendes gilt für das Ausführungsbeispiel 3, bei dem die durch ein plasmaaktiviertes CVD-Verfahren aufgetragenen Schichten aus dem Hartstoff TiN gewählt wurden.

Die erfindungsgemäße Ausführung ist ein beschichteter Hartmetallgrundkörper, dessen $\alpha$-Aluminiumoxid-Schicht von 5 $\mu$m mit einem CVD-Verfahren bei 600 °C hergestellt worden ist, dessen die Hartstoffbildende reaktive Gasatmosphäre aus Aluminiumchlorid, Kohlendioxid und Wasserstoff durch eine Glimmentladung teilweise ionisiert war (Plasmaaktivierung). Die Beschichtung erfolgte direkt auf dem Hartmetallkörper bei einer Beschichtungstemperatur von 600°C und einem Gadruck von 250 Pa. Das Ergebnis war eine gut haftende, etwa 5 $\mu$m dicke Schicht auf einer Wendeschneidplatte, dessen Röntgenbeugungsuntersuchung zeigte, daß in der Schicht die erfindungsgemäße Feinstruktur des $\alpha$-Aluminiumoxids vorliegt. Die Halbwertsbreite der (113)-Linie war etwa fünfmal größer als die oben definierte natürliche Halbwertsbreite eines kompakten Aluminiumoxid-Körpers.

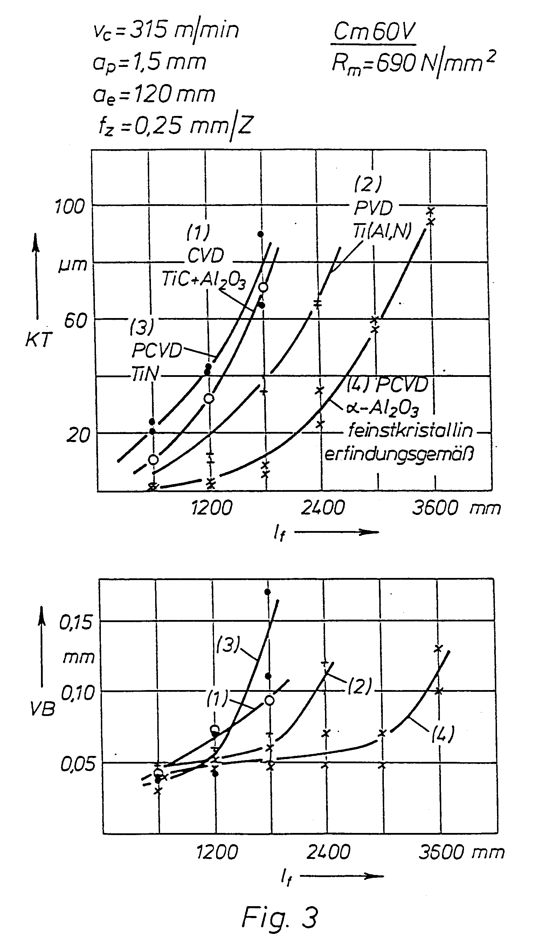

Die in der Tabelle 1 aufgeführten vier Ausführungsformen der Wendeschneidplatten wurden in einer Fräsmaschine unter gleichbleibenden Bedingungen geprüft. Hierzu wurde ein Stirnfräskopf mit jeweils einer Wendeschneidplatte bestückt und ein 120 mm breiter und 600 mm langer Stahlblock aus dem Stahl Cm60V (Rm 690 N/mm$^2$) bearbeitet. Die Schnittiefe betrug 1,5 mm und der Vorschub war 0,25 mm/Zahn. Es wurde eine vergleichsweise hohe Schnittgeschwindigkeit von 315 m/min gewählt. Nach jeder Bearbeitung der gesamten Länge des Stahlblockes wurde der Verschleiß der Wendeschneidplatten mit Meßmikroskopen bestimmt. Als Maß für den Verschleiß wurde die Tiefe der sich auf der Spanfläche ausbildenden Kolkmulde (KT) und die Breite des Verschleißes auf der Freifläche (VB) gemessen. Eine zusammenfassende Darstellung der Meßergebnisse ist Fig. 3 zu entnehmen. Die Darstellung zeigt, daß mit der erfindungsgemäßen, feinkristallinen $\alpha$-Al$_2$O$_3$-Beschichtung nach Ausführungsbeispiel 4 (siehe Tabelle 1) etwa die doppelte Materialmenge als mit der "normalkristallinen" $\alpha$-Al$_2$O$_3$-Beschichtung nach Ausführungsbeispiel 1 von dem Werkstück abgetragen werden kann. Auch im Vergleich zu den bei Temperaturen von 500°C bzw. 550°C aufgetragenen Beschichtungen nach Ausführungsbeispielen 2 und 3 zeigt die erfindungsgemäße Beschichtung eine überlegene Schneidleistung.

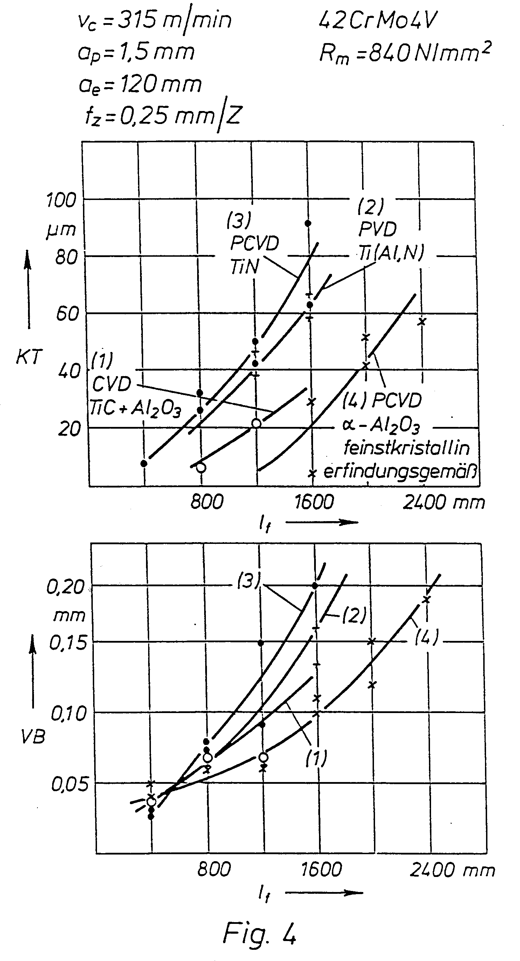

In einem weiteren Versuch wurden die in Tabelle 1 gezeigten Ausführungsformen der Wendeschneidplatten bei der Bearbeitung eines anderen Materials, nämlich dem legierten Stahlwerkstoff 42CrMo4V (Rm 840 N/mm$^2$) geprüft. Die Versuchsbedingungen waren bis auf die Abmessungen des Werkstückes (Länge des Blockes 400 mm) die gleichen wie im vorherigen Anwendungsbeispiel. Die Ergebnisse sind in Fig. 4 dargestellt. Auch hier erweist sich das überlegene Leistungsverhalten der Wendeschneidplatten mit der erfindungsgemäßen, feinstkristallinen $\alpha$-Al$_2$O$_3$-Beschichtung.

## Patentansprüche

1. Verbundkörper, bestehend aus einem Hartmetall- oder Cermet-Substratkörper oder einem Substratkörper aus einer Nickel- oder Cobaltbasislegierung und einer oder mehreren Oberflächenschichten, von denen mindestens eine, vorzugsweise die äußere, aus $\alpha$-Al$_2$O$_3$ besteht, die eine feinkristalline Struktur aufweist bzw. aufweisen, deren durch die Halbwertbreiten der mit CuK$_\alpha$-Röntgenstrahlung gemessenen Beugungslinien eine mindestens dreimal so große Halbwertsbreite als die eines pulverförmigen Kompaktkörpers aus $\alpha$-Al$_2$O$_3$ oder einer mit einem CVD-Verfahren bei 1000 bis 1100°C aufgetragenen $\alpha$-Al$_2$O$_3$-Schicht aufweisen und die bei Substrattemperaturen von 400 bis 750°C mittels des PlasmaCVD-Verfahrens aufgetragen worden ist, wobei die Plasmaaktivierung an dem als Kathode geschalteten Substratkörper mit einer gepulsten Gleichspannung herbeigeführt worden ist.

2. Verbundkörper nach Anspruch 1, dadurch gekennzeichnet, daß die durch die Miller-Indizes (113) indizierte und beim Beugungswinkel 43,4° der 2$\theta$-Skala bei CuK$_\alpha$-Röntgenstrahlung auftretende Röntgenbeugungslinie mindestens die dreifache, vorzugsweise mindestens die vierfache Halbwertsbreite der entsprechenden Röntgenbeugungslinie von pulverförmigen $\alpha$-Aluminiumoxid aufweist.

3. Verbundkörper nach Anspruch 1 oder 2, dadurch gekennzeichnet, daß die Dicke der Al$_2$O$_3$-Beschichtung 1 bis 12 $\mu$m, vorzugsweise 2 bis 6 $\mu$m, beträgt.

4. Verbundkörper nach einem der Ansprüche 1 bis 3, dadurch gekennzeichnet, daß die Beschichtung aus Al$_2$O$_3$ aus 49 bis 52,5 Massen-% Aluminium, 46 bis 47,5 Massen-% Sauerstoff und 0,5 bis 3,5 Massen-% Chlor besteht.

5. Verbundkörper nach einem der Ansprüche 1 bis 4, dadurch gekennzeichnet, daß die Beschichtung teilweise aus feinstkristallinem $\alpha$-Al$_2$O$_3$ und/oder nanokristalllnem Al$_2$O$_3$ und teilweise aus amorphem Al$_2$O$_3$ besteht.

6. Verbundkörper nach einem der Ansprüche 1 bis 5, dadurch gekennzeichnet, daß das Elektronenbeugungsbild der Beschichtung aus Aluminiumoxid Interferenzringe aufweist, die einzelnen Netzebenen von $\alpha$-Al$_2$O$_3$ zugeordnet werden können.

EP 0 577 678 B1

7. Verbundkörper nach einem der Ansprüche 1 bis 6, gekennzeichnet durch mindestens eine Zwischenschicht aus Carbiden, Carbonitriden, Nitriden, Boriden und/oder Oxiden der Elemente der Gruppen IVa bis VIa des Periodensystems.

8. Verbundkörper nach Anspruch 7, dadurch gekennzeichnet, daß mindestens eine Schicht aus TiC und/oder TiN besteht.

9. Verbundkörper nach Anspruch 7 oder 8, dadurch gekennzeichnet, daß die an den Substratkörper angrenzende Schicht eine Aluminiumoxidschicht nach den Ansprüchen 1 bis 6 ist.

10. Verwendung des Verbundkörpers nach einem der Ansprüche 1 bis 9 als Schneidwerkstoff zur spanenden Bearbeitung, als Hochtemperaturwerkstoff, vorzugsweise in Brennkammern, oder als verschleißfester Werkstoff für aneinanderreibende Teile, insbesondere Nockenwellen, oder als Stranggußwerkzeug oder Druckgußform.

11. Verfahren zur Herstellung einer Oberflächenbeschichtung aus $\alpha$-Al$_2$O$_3$ auf einem Hartmetall- oder Cermet-Substratkörper oder einem Substratkörper aus einer Nickel- oder Cobaltbasislegierung und mindestens einer hierauf abgeschiedenen Hartstoffschicht, dadurch gekennzeichnet, daß die $\alpha$-Al$_2$O$_3$-Beschichtung bei Substrattemperaturen von 400 bis 750°C mittels des Plasma-CVD-Verfahrens durchgeführt wird, wobei die Plasmaaktivierung an dem als Kathode geschalteten Substratkörper mit einer gepulsten Gleichspannung herbeigeführt wird.

**Claims**

1. Composite body consisting of a hard metal- or cermet-substrate body or a substrate body made of a nickel-based or cobalt-based alloy and one or more surface layers, of which at least one, preferably the outer layer, consists of $\alpha$-Al$_2$O$_3$, having a fine-crystalline structure the diffraction lines of which when measured through the half-width values with CuK$_\alpha$-X-rays have half-width values at least three times bigger as those of a powdered compact body of $\alpha$-Al$_2$O$_3$ or of an $\alpha$-Al$_2$O$_3$ layer produced through a CVD process at 1000°C to 1100°C, and being applied at substrate temperatures of 400 to 750°C by means of a plasma-CVD-process, whereby the plasma activation is produced by a pulsed direct voltage at the substrate body serving as cathode.

2. Composite body according to claim 1, characterized in that X-ray diffraction lines indexed through the Miller indices (113) and appearing at a diffraction angle of 43.4° of the $2\theta$ scale a CuK$_\alpha$-X-ray show at least the threefold, preferably at least fourfold half-width value of the corresponding X-ray diffraction line of powdered $\alpha$-aluminum oxide.

3. Composite body according to claim 1 or 2, characterized in that the thickness of the Al$_2$O$_3$ coating reaches 1 to 12 $\mu$m, preferably 2 to 6 $\mu$m.

4. Composite body according to claims 1 to 3, characterized in that the coating of Al$_2$O$_3$ consists of 49 to 52.5 % by mass aluminum, 46 to 47.5 % by mass oxygen and 0.5 to 3.5 % by mass chlorine.

5. Composite body according to one of claims 1 to 4, characterized in that the coating consists partially of fine-crystalline $\alpha$-Al$_2$O$_3$ and/or nancrystalline Al$_2$O$_3$ and partially of amorphous Al$_2$O$_3$.

6. Composite body according to one of claims 1 to 5, characterized in that the electron diffraction image of the aluminum oxide coating shows interference rings which can be associated with individual planes of $\alpha$-Al$_2$O$_3$.

7. Composite body according to one of claims 1 to 6, characterized by at least one intermediate layer of carbides, carbonitrides, nitrides, borides and/or oxides of elements of Groups IVa to VIa of the periodic table of elements.

8. Composite body according to claim 7, characterized in that at least one layer consists of TiC and/or TiN.

7

9. Composite body according to claim 7 or 8, characterized in that the layer directly coating the substrate body is an aluminum oxide layer according to claims 1 to 6.

10. Use of the Composite body according to one of claim 1 to 9 as a cutting material in machining processes, as a high-temperature material, preferably in combustion chambers, or as a wear-resistant material for part in frictional contact, particularly cam shafts, or as a tool in continuous casting or as a die-casting mold.

11. Process for the producing a surface coating of $\alpha$-Al$_2$O$_3$ on a substrate body of hard metal or cermet or on a substrate body of a nickel-based or cobalt-based alloy and at least one layer of hart material deposited thereon, characterized in that the $\alpha$-Al$_2$O$_3$ coating is applied at substrate temperatures of 400 to 750° by means of a plasma-activated CVD process, whereby the plasma activation is produced by a pulsed direct voltage at the substrate body serving as cathode.

**Revendications**

1. Corps composite, constitué d'un corps formant substrat en métal dur ou en cermet, ou d'un corps formant substrat en alliage de base en nickel ou en cobalt, et d'une ou plusieurs couches de revêtement, dont au moins l'une, de préférence la couche extérieure, est constituée de $\alpha$-Al2O3, cette couche, ou ces couches, présentant une structure cristalline fine, dont les lignes de diffraction, mesurées par la largeur de bande moyenne du rayonnement X à CuK$_\alpha$, présentent une largeur de bande moyenne trois fois plus grande que celui d'un corps compact pulvérulent en $\alpha$-Al2O3, ou d'une couche d'$\alpha$-Al2O3 déposée à 1000 à 1100°C par un procédé CVD, et qui ont été déposées avec des températures de substrat de 400 à 750°C par le procédé au plasma CVD, étant entendu que l'activation plasma a été exécutée sur le corps formant substrat, branché comme cathode, avec une tension continue pulsée.

2. Corps composite suivant la revendication 1, caractérisé en ce que la ligne de diffraction X, indexée au moyen de l'indice Miller (113) et appliquée avec un angle de diffraction de 43,4° de l'échelle 2. pour un rayonnement X à CuK$_\alpha$ présente au moins trois fois, de préférence au moins quatre fois la largeur moyenne de bande de la ligne de diffraction X correspondante de l'oxyde d'aluminium $\alpha$ pulvérulent.

3. Corps composite suivant la revendication 1 ou la revendication 2, caractérisé en ce que l'épaisseur du revêtement d'Al2O3 est de 1 à 12 micromètres, de préférence 2 à 6 micromètres.

4. Corps composite suivant l'une quelconque des revendications 1 à 3, caractérisé en ce que le revêtement d'Al2O3 est constitué par 49 à 52,5 %, en masse, d'aluminium, de 46 à 47,5 %, en masse, d'oxygène et de 0,5 à 3,5 %, en masse, de chlore.

5. Corps composite suivant l'une quelconque des revendications 1 à 4, caractérisé en ce que le revêtement est constitué, pour partie, d'$\alpha$-Al2O3 à cristallisation la plus fine et/ou de nanocristaux d'Al2O3, et, pour partie, d'Al2O3 amorphe.

6. Corps composite suivant l'une quelconque des revendications 1 à 5, caractérisé en ce que l'image de diffraction des électrons du revêtement d'oxygène d'aluminium présente des anneaux d'interférence qui peuvent être associés aux différents plans de réseau de l'$\alpha$-Al2O3.

7. Corps composite suivant l'une quelconque des revendications 1 à 6, caractérisé par au moins une couche intermédiaire en carbure, en carbonitrure, en nitrure, en borure et/ou en oxydes des éléments des groupes IVa à VIa de la classification périodique.

8. Corps composite suivant la revendication 7, caractérisé en ce qu'au moins une couche est constituée de TiC et/ou de TiN.

9. Corps composite suivant la revendication 7 ou la revendication 8, caractérisé en ce que la couche délimitant le corps formant substrat est une couche d'oxyde d'aluminium suivant les revendications 1 à 6.

**10.** Utilisation du corps composite suivant l'une quelconque des revendications 1 à 9 comme matériau de coupe pour usinage avec enlèvement de copaux, comme matériau pour haute température, de préférence dans des chambres de combustion, ou comme matériau résistant à l'usure pour des pièces frottant l'une contre l'autre, en particulier des arbres à cames, ou comme outils de coulée continue ou de moules d'injection de fonte sous pression.

**11.** Procédé de fabrication d'un revêtement de surface en $\alpha$-Al2O3 sur un corps formant substrat en métal dur ou en cermet, ou sur un corps formant substrat en alliage de base en nickel ou en cobalt, et d'au moins une couche en matériau dur déposé sur lui, caractérisé en ce que le revêtement d'$\alpha$-Al2O3 est exécuté à des températures du substrat de 400 à 750 °C au moyen du procédé CVD au plasma, étant entendu que l'activation plasma est exécutée sur le corps formant substrat, branché comme cathode, avec une tension continue pulsée.

α- $Al_2O_3$

TiC

Hartmetall

4250:1

Fig. 1a

α- $Al_2O_3$
feinstkristallin

Hartmetall

8250:1

Fig. 1b

Fig. 2a

Fig. 2b

Fig. 2c

$$v_c = 315 \ m/min$$
$$a_p = 1,5 \ mm$$
$$a_e = 120 \ mm$$
$$f_z = 0,25 \ mm/Z$$

$$\underline{Cm \, 60V}$$
$$R_m = 690 \ N/mm^2$$

Fig. 3

Fig. 4